(19) Europäisches Patentamt
European Patent Office
Office européen des brevets

(11) **EP 4 685 789 A1**

(12) **EUROPEAN PATENT APPLICATION**
published in accordance with Art. 153(4) EPC

(43) Date of publication:
**28.01.2026 Bulletin 2026/05**

(21) Application number: **24774524.3**

(22) Date of filing: **15.02.2024**

(51) International Patent Classification (IPC):
**G10K 15/04** (2006.01)   **B60Q 5/00** (2006.01)
**H04R 3/00** (2006.01)

(52) Cooperative Patent Classification (CPC):
**B60Q 5/00; G10K 15/04; H04R 3/00**

(86) International application number:
**PCT/JP2024/005368**

(87) International publication number:
**WO 2024/195379 (26.09.2024 Gazette 2024/39)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.03.2023 JP 2023044828**

(71) Applicant: **Denso Electronics Corporation
Anjo-city, Aichi 446-8503 (JP)**

(72) Inventors:
• **YAMAMOTO Chikara
Anjo-city, Aichi 446-8503 (JP)**
• **TANI Shinji
Anjo-city, Aichi 446-8503 (JP)**

(74) Representative: **Kuhnen & Wacker
Patent- und Rechtsanwaltsbüro PartG mbB
Prinz-Ludwig-Straße 40A
85354 Freising (DE)**

(54) **SOUND GENERATION CONTROL DEVICE**

(57)     A sound output unit generates a sound based on generation waveform data (Da). A basic waveform selection unit (30) selects, as a selection basic waveform table (TB1), a basic waveform table from multiple basic waveform tables (301a) stored in advance, each of the multiple basic waveform tables having a basic waveform (301b) providing a basis of the generation waveform data; A frequency selection unit (32) selects, as a selection frequency table (TB2), a frequency table from multiple frequency tables (321a) stored in advance, each of the multiple frequency tables representing a relationship between a playback frequency (fb) and elapsed time, the playback frequency indicating the number of times by which the basic waveform is transformed and repeated per unit time. A frequency applying unit (34) generates, as generation waveform data, a waveform (341) in which a frequency applied waveform (34a) is repeated successively, the frequency applied waveform being obtained by transforming the basic waveform in a time axis direction (Dt) so that a time width (Tfa) of the basic waveform of the selection basic waveform table becomes one period (Tfb) of the playback frequency of the selection frequency table.

FIG. 1

## Description

CROSS REFERENCE TO RELATED APPLICATION

This application is based on Japanese Patent Application No. 2023-044828 filed on March 21, 2023, the disclosure of which is incorporated herein by reference.

TECHNICAL FIELD

The present disclosure relates to a sound generation control device that controls a sound output unit to output a sound.

BACKGROUND ART

As this type of control device, for example, an electrical device described in Patent Literature 1 is known. The electrical device described in Patent Literature 1 is mounted on automobiles such as hybrid automobiles or electric automobiles. For example, when the automobile is traveling at a low speed, the electrical device outputs an approach warning sound to notify pedestrians around the automobile that the automobile is approaching.

In the electrical device of Patent Literature 1, a memory device included therein stores test sound source data (for example, sound source data for marker sound and sweep sound) for testing the electrical device itself, and the electrical device can use the test sound source data to output a sound from a sound output unit.

PRIOR ART LITERATURE

PATENT LITERATURE

Patent Literature 1: JP 2013-018352 A

SUMMARY

For example, in a sound generation control device included in an alarm product that outputs approach warning sounds and the like from a sound output unit, multiple pieces of sound source data are normally stored in a storage device, such as a ROM of the sound generation control device. The electrical device of the above-mentioned Patent Literature 1 has a similar configuration.

In a conventional sound generation control device, in order to meet the need to change only the tone of sound corresponding to user requirement, for the same notification function that has same sound pattern, such as same frequency and same volume change, it is necessary to store, in a storage device, independent sound source data that differed for each tone.

Since an available recording time for sound source data depends on a capacity of the storage device, the capacity of storage device may become insufficient due to the increased amount of sound source data. Therefore, an increase in the amount of sound source data requires an increase in the capacity of storage device, and this may cause an increase in the size of the product and an increase in the manufacturing cost of the product. When it is necessary to store the test sound source data in a storage device of the sound generation control device, as in the electrical device of Patent Literature 1, the recording time, that is, recording length of sound source data (for example, sound source data used for alarm sound, or the like) other than the test sound source data is limited by the amount of test sound source data stored in the storage device.

For these reasons, it is necessary to provide a technology that enables output of different types of notification sounds, while suppressing the size of data that serves as the sound sources of various notification sounds. This difficulty is studied by the inventors of the present disclosure.

In view of the above-described difficulty, an object of the present disclosure is to provide a sound generation control device that enables output of various sounds while suppressing the size of data that serves as the sound source of various sounds.

In order to achieve the above object, according to an aspect of the present disclosure, a sound generation control device included in a sound generation system is provided. The sound generation control device generates generation waveform data indicating a waveform of sound. The sound generation system causes a sound output unit to output a sound generated based on the generation waveform data. The sound generation control device includes a basic waveform selection unit, a frequency selection unit, and a frequency applying unit. The basic waveform selection unit is configured to select, as a selection basic waveform table, a basic waveform table from multiple basic waveform tables stored in advance, and each of the multiple basic waveform tables has a basic waveform providing a basis of the generation waveform data. The frequency selection unit is configured to select, as a selection frequency table, a frequency table from multiple frequency tables stored in advance. Each of the multiple frequency tables represents a relationship between a playback frequency and elapsed time, and the playback frequency indicates the number of times by which the basic waveform is transformed and repeated per unit time. The frequency applying unit is configured to generate, as generation waveform data, a waveform in which a frequency applied waveform is repeated successively. The frequency applied waveform is obtained by transforming the basic waveform in a time axis direction so that a time width of the basic waveform of the selection basic waveform table becomes one period of the playback frequency of the selection frequency table.

According to the above configuration, the total amount of data for the multiple basic waveform tables and multiple frequency tables is smaller compared with a case where multiple pieces of sound source data are prepared, in advance, and stored independently for all combinations of the multiple basic waveform tables and the multiple frequency tables. Therefore, it is possible to reduce the size of data that serves as the sound sources of various sounds. As a result, various sounds can be generated by combining multiple basic waveform tables with the multiple frequency tables.

In some sections of the application document, some elements may be provided with reference symbols in parentheses. In this case, the reference symbol merely indicates an example of correspondence between the element and the specific configuration of the embodiment to be described later. Therefore, the present disclosure is not limited by the description of the reference symbols.

BRIEF DESCRIPTION OF DRAWINGS

FIG. 1 is a block diagram showing a general configuration of a sound generation system according to a first embodiment.

FIG. 2 is a diagram showing a first example of basic waveform among multiple basic waveforms of respective basic waveform tables.

FIG. 3 is a diagram showing a second example of basic waveform among multiple basic waveforms of respective basic waveform tables.

FIG. 4 is a diagram showing a first example of frequency table among multiple frequency tables.

FIG. 5 is a diagram showing a second example of frequency table among multiple frequency tables.

FIG. 6 is a diagram showing a first example of volume table among multiple volume tables.

FIG. 7 is a diagram showing a second example of volume table among multiple volume tables.

FIG. 8 shows, in (a), the firs example of basic waveform shown in FIG. 2, shows, in (b), a frequency applied waveform generated based on the basic waveform of the first example for comparing the frequency applied waveform with the basic waveform of the first example.

FIG. 9 is a diagram showing a frequency applied continuous waveform in which the frequency applied waveform shown in (b) of FIG. 8 is repeated successively.

FIG. 10 shows diagrams for explaining a resampling process performed by the frequency applying unit of FIG. 1 for obtaining a frequency applied waveform, in which (a) shows an enlarged view of a portion of the basic waveform providing a basis of the frequency applied waveform and a portion of an intermediate waveform along the basic waveform, and (b) shows an enlarged view of a portion of the frequency applied waveform generated from the basic waveform via the intermediate waveform.

DESCRIPTION OF EMBODIMENTS

The following will describe embodiments of the present disclosure with reference to the accompanying drawings. In the following embodiments including other embodiments to be described later, the same or equivalent components are denoted by the same reference symbol in the drawings.

(First Embodiment)

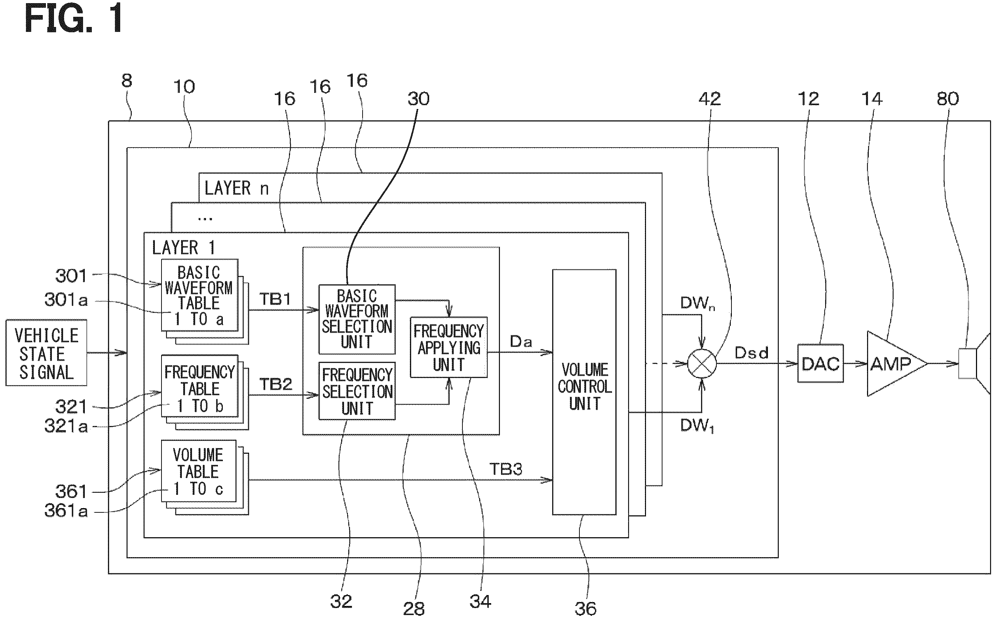

In the present embodiment, a sound generation system 8 shown in FIG. 1 is a warning device mounted on a vehicle, for example, a hybrid vehicle or an electric vehicle. The sound generation system 8 includes a sound output unit 80, such as a speaker or a buzzer, and controls the sound output unit 80 to output various warning sounds.

In addition to the sound output unit 80, the sound generation system 8 includes a microcomputer 10, a digital-to-analog converter 12, and a power amplifier 14. In the description of the present embodiment, the digital-to-analog converter 12 is also referred to as a DAC 12, and the power amplifier 14 is also referred to as an AMP 14.

The microcomputer 10 outputs sound data Dsd to the DAC 12. The sound data Dsd is digital data representing a sound waveform (for example, a PCM waveform). The DAC 12 converts the sound data Dsd input from the microcomputer 10 into an analog signal, and outputs the analog signal to the AMP 14.

The AMP 14 supplies a current corresponding to the analog signal, which is output from the DAC 12 and input to the AMP 14, based on applying of a voltage from a constant voltage source (not shown). The sound output unit 80 generates a sound in response to the current being supplied from the AMP 14. The sound output unit 80 generates a sound in accordance with the sound generation data Dsd.

The microcomputer 10 is an electronic control device, and is configured as an on-board microcomputer including a CPU, a RAM, a ROM, a non-volatile rewritable memory, and the like (not shown). The microcomputer 10 reads out and executes a computer program stored in the ROM or the non-volatile rewritable memory, which are non-transitory tangible storage medium. A method corresponding to the computer program is performed when the computer program is executed.

As shown in FIG. 1, the microcomputer 10 includes multiple layers 16 and a mixer 42 as functional blocks. Each of the multiple layers 16 outputs output waveform data DW, which corresponds to a basis of the sound data Dsd, to the mixer 42. Therefore, multiple output waveform data DW are input to the mixer 42. Each of the layers 16 includes a waveform data generation unit 28, a volume control unit 36, a first storage 301, a second storage 321, and a third storage 361. In the present embodiment, each layer 16 included in the microcomputer 10 corresponds to a sound generation control device that generates generation waveform data Da, which will be described later.

The output waveform data DW is digital data representing a sound waveform, such as a PCM waveform. In FIG. 1, "a" in "1 to a", "b" in "1 to b", "c" in "1 to c", and "n" in "layer n" are each an integer of 2 or more, and "n" indicates the number of layers 16 and is also indicates the number assigned to the layer 16. Each subscripted DW indicates output waveform data DW. For example, DWn indicates output waveform data DW output from the n-th layer 16.

The mixer 42 mixes multiple pieces of output waveform data DW, which are input to the mixer 42 from the multiple layers 16. The mixer 42 then outputs the sound data Dsd, which is the waveform data (that is, synthesized waveform data) generated by the mixing, to the DAC 12.

The waveform data generation unit 28 generates generation waveform data Da, which is the basis of the output waveform data DW, and outputs the generation waveform data Da to the volume control unit 36. The waveform data generation unit 28 has a basic waveform selection unit 30, a frequency selection unit 32, and a frequency applying unit 34.

As described above, since the output waveform data DW is the basis of the sound data Dsd, the sound output unit 80 generates and outputs a sound based on the output waveform data DW. Since the generation waveform data Da is the basis of the output waveform data DW, the sound output unit 80 generates and outputs a sound based on the generation waveform data Da. The generation waveform data Da is digital data representing a sound waveform, such as a PCM waveform.

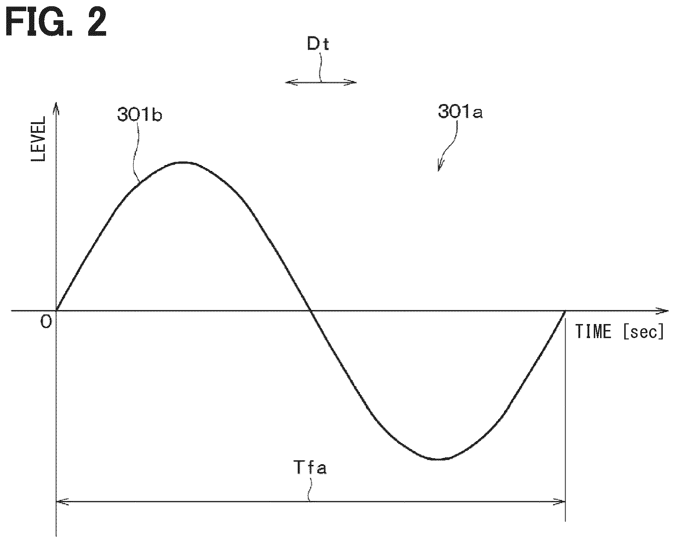

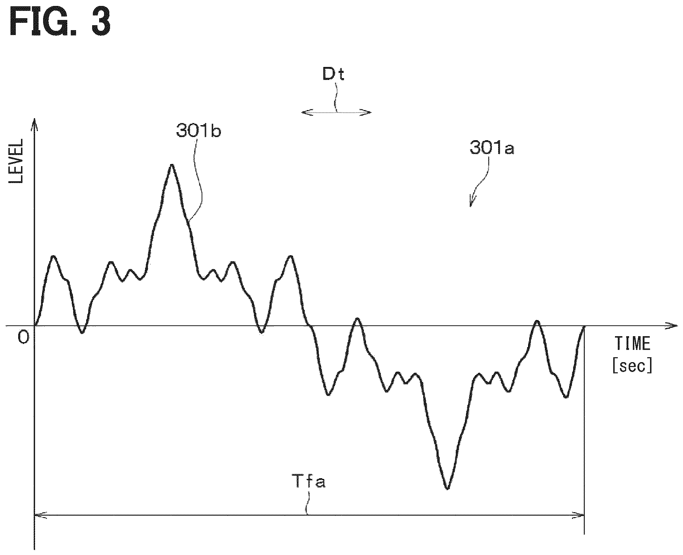

The first storage 301, the second storage 321, and the third storage 361 are each configured by a storage medium, for example, a ROM included in the microcomputer 10. The first storage 301 stores, in advance, multiple basic waveform tables 301a. As shown in FIG. 2 and FIG. 3, each of the basic waveform tables 301a has a basic waveform 301b of a sound waveform (for example, a digital waveform such as a PCM waveform), which corresponds to a basis of the generation waveform data Da.

A first example of the basic waveform 301b, which is one of the multiple basic waveforms 301b, is shown in FIG. 2, and a second example of the basic waveform 301b, which is another one of the multiple basic waveforms different from the first example, is shown in FIG. 3. The basic waveform 301b is stored in the first storage 301 and is read out as a loop sound, which is output repeatedly in successive manner.

The basic waveform 301b of the first example shown in FIG. 2 is a sine wave, and the basic waveform 301b of the second example shown in FIG. 3 is an arbitrary waveform that is arbitrarily determined. As shown in FIG. 2 and FIG. 3, the basic waveform 301b indicates the relationship between a level and elapsed time. The level corresponds to a voltage of an analog signal corresponding the sound waveform (that is, the analog sound waveform), and an amplitude of the level corresponds to an amplitude of the voltage of the analog sound waveform.

The basic waveform 301b stored in the first storage 301 has a time width Tfa indicating an occupancy by the basic waveform 301b in the time axis direction Dt, and the time width Tfa corresponds to a period of the basic waveform 301b. The time width Tfa of the basic waveform 301b is one period of the basic waveform 301b, and the first storage 301 stores waveform data corresponding to one period of the basic waveform 301b. For example, the basic waveform 301b is ultimately compressed in the time axis direction Dt when being used, but the time width Tfa of the basic waveform 301b stored in the first storage 301 is set to be sufficiently long compared with one period of the compressed basic waveform 301b.

The time width Tfa of basic waveform 301b, which is a digital waveform, is set such that the sampling number Nbt has an integer value for the sampling frequency fss of the sound generation system 8. The sampling number Nbt of the basic waveform 301b corresponding to the data amount of basic waveform 301b.

For example, when the time width Tfa of basic waveform 301b is set to Tfa = 20 msec and the sampling frequency fss of the sound generation system 8 is fss = 32 kHz, then the sampling number Nbt of the basic waveform 301b is Nbt = fss x Tfa = 640 samples. When the time width Tfa of the basic waveform 301b is set to Tfa = 20 msec, the basic waveform frequency fa, which is the frequency of repetition when the basic waveform 301b is simply repeated successively, is fa = 1/Tfa = 50 Hz.

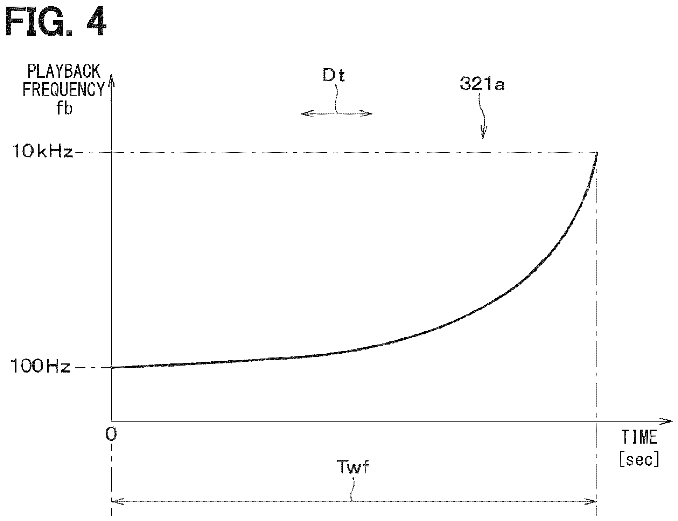

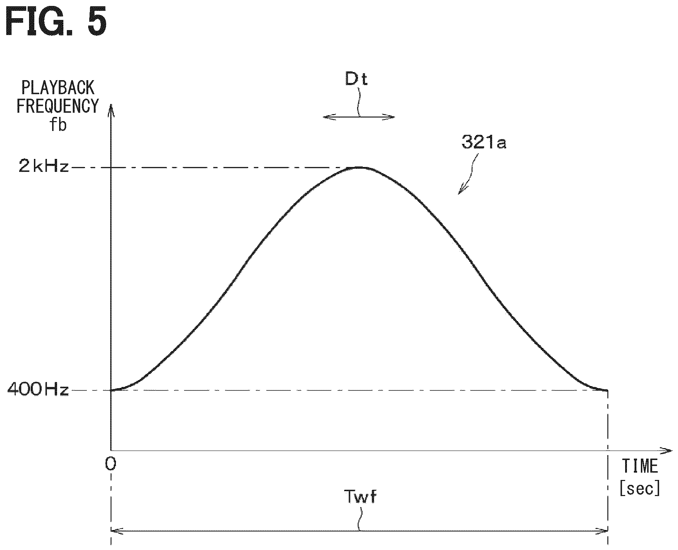

The second storage 321 stores multiple frequency tables 321a in advance. As shown in FIG. 4 and FIG. 5, each of the multiple frequency tables 321a represents a playback frequency-time relationship, which is a relationship between a playback frequency fb and an elapsed time. The playback frequency fb is the number of times by which the transformed basic waveform 301b is repeated per unit time (specifically, 1 sec) when the basic waveform 301b is transformed and repeated. The transformation of basic waveform 301b (specifically, compression in the time axis direction Dt) will be described later.

A first example of the frequency table 321a, which is one of the multiple frequency tables 321a, is shown in FIG. 4, and a second example of the frequency table 321a, which is another one of the multiple frequency tables different from the first example, is shown in FIG. 5. The frequency table 321a has a time width Twf indicating an occupancy by the playback frequency-time relationship in the time axis direction Dt.

The first example of frequency table 321a shown in FIG. 4 is used to log-sweep the frequency of playback sound when the output waveform data DW is played back. An example of log-sweeping the frequency of playback sound is when inspecting the sound output unit 80. In the frequency table 321a of the first example, the time width Twf of frequency table 321a is a frequency sweep time when the playback frequency fb is log-swept, and the playback frequency fb is log-swept from 100 Hz to 10 kHz in the first example of frequency table shown in FIG. 4.

The second example of frequency table 321a shown in FIG. 5 is used to vary the frequency of playback sound (that is, vary the sound interval) when the output waveform data DW is played back. A case of varying the frequency of playback sound is when outputting a notification sound or an alarm sound.

The frequency table 321a of the second example corresponds to one period in the repeated variation of the playback frequency fb, and can be used repeatedly. That is, in the frequency table 321a of the second example, the time width Twf of the frequency table 321a corresponds to one period in the repeated variation of the playback frequency fb, and the playback frequency fb varies between 400 Hz and 2 kHz.

In the present embodiment, the frequency table 321a is digital data and includes a set of relation points indicating the relation between the playback frequency fb and the elapsed time. The update period for updating the playback frequency fb in the frequency table 321a (that is, the temporal resolution of frequency table 321a) is set to about 1 msec. The update period of playback frequency fb is set in advance based on the balance between the amount of data in the frequency table 321a and time responsiveness or a processing capacity of the microcomputer 10, or the like.

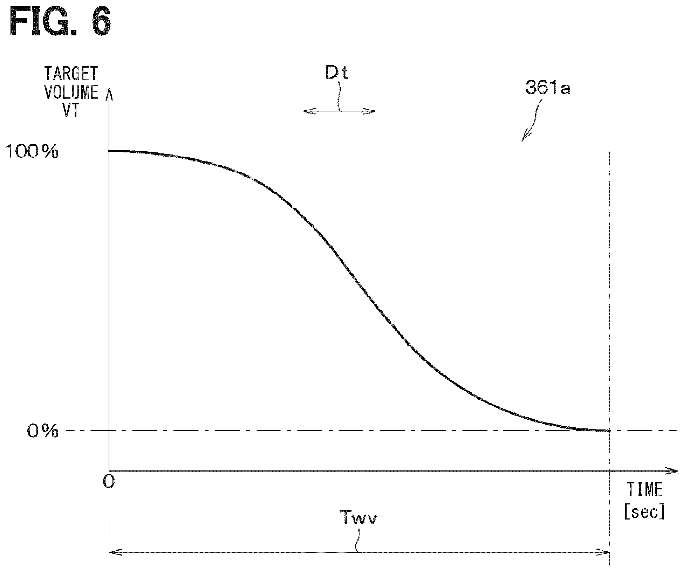

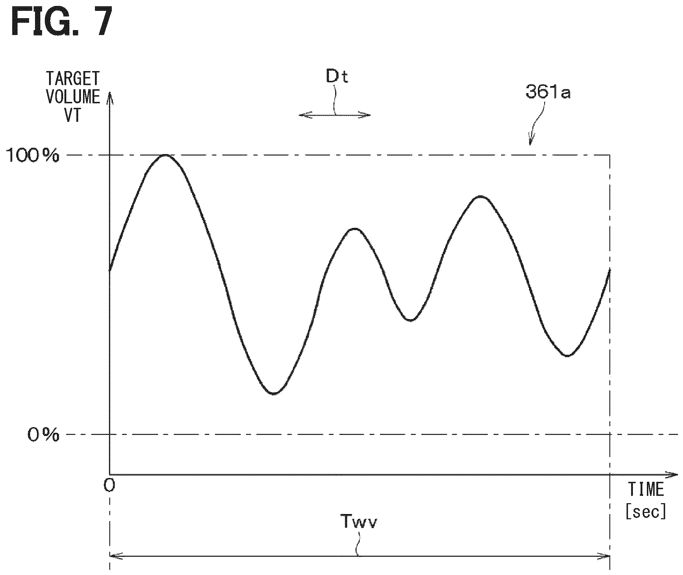

The third storage 361 stores multiple volume tables 361a in advance. As shown in FIG. 6 and FIG. 7, each of the multiple volume tables 361a represents a target volume-time relationship, which is a relationship between a target volume VT and elapsed time. The target volume VT is a target value of volume when adjusting the volume of generation waveform data Da.

FIG. 6 shows a first example of the volume table 361a, which is one example of the multiple volume tables 361a. FIG. 7 shows a second example of the volume table 361a, which is another one example different from the first example. The volume table 361a has a time width Twv indicating an occupancy by the target volume-time relationship in the time axis direction Dt.

The first example of volume table 361a shown in FIG. 6 is used when the volume of the playback sound is smoothly faded out when the output waveform data DW is played back. Examples of cases where the playback sound is to be smoothly faded out in volume include a case where a decaying sound is to be generated, and a case where an intermittent sound in which the volume fades out repeatedly is to be generated. In the first example of volume table 361a, the time width Twv of the volume table 361a is a volume attenuation time during which a fade-out of volume continues, and the target volume VT gradually decreases from 100% to 0% over time.

The second example of volume table 361a shown in FIG. 7 is used to express a fluctuation of the playback sound when the output waveform data DW is played back. For example, when volume tables 361a with different fluctuations from one another are used in respective layers 16, a regularity or repetitiveness of the playback sound is reduced, preventing a listener from becoming bored due to the playback sound. Thus, it is possible to reduce the amount of data in the volume table 361a and maintain acceptability.

In the present embodiment, the volume table 361a is digital data and includes a set of relation points indicating the relation between the target volume VT and elapsed time. The update period for updating the target volume VT in the volume table 361a (that is, the temporal resolution of the volume table 361a) is set to about 20 msec. The update period of target volume VT is set in advance based on the balance between the amount of data in the volume table 361a and time responsiveness, or a processing capacity of the microcomputer 10, or the like.

The basic waveform selection unit 30 shown in FIG. 1 selects, as a selection basic waveform table TB1, one basic waveform table 301a from the multiple basic waveform tables 301a stored in the first storage 301. For example, the basic waveform selection unit 30 selects the selection basic waveform table TB1 according to a predetermined rule in response to a vehicle state signal. The vehicle state signal indicates a state of the vehicle in which the sound generation system 8 is installed (for example, the vehicle's driving condition, the remaining amount of fuel, the conditions around the vehicle, or the like), and is input to the microcomputer 10 from various sensors equipped to the vehicle.

The frequency selection unit 32 selects one frequency table 321a, as a selection frequency table TB2, from the multiple frequency tables 321a stored in the second storage 321. For example, the frequency selection unit 32 selects the selection frequency table TB2 according to a predetermined rule in response to the vehicle state signal.

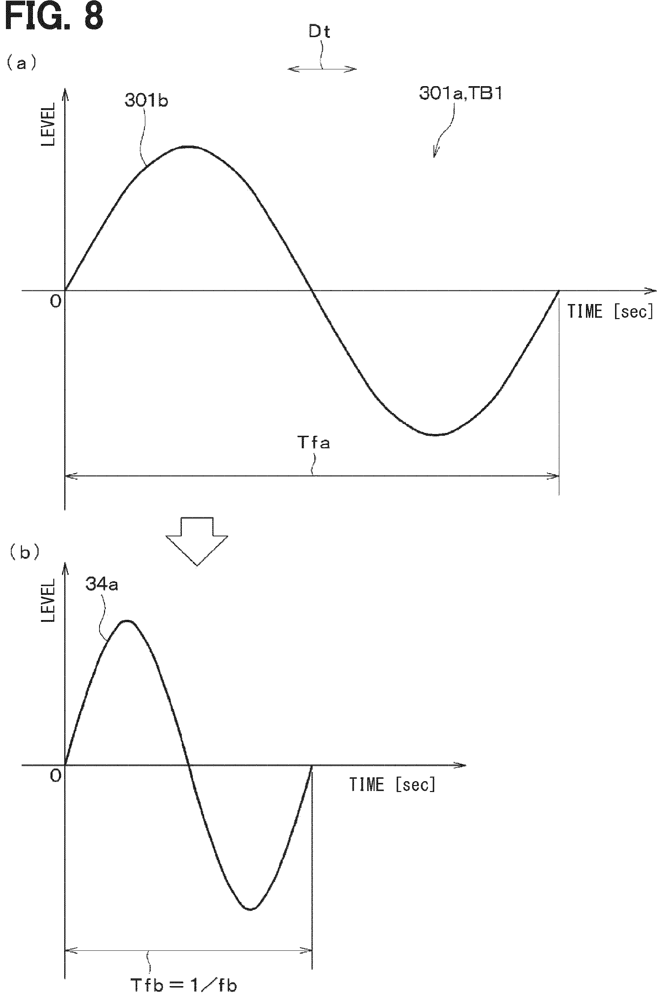

The frequency applying unit 34 generates a frequency applied waveform 34a based on the selection basic waveform table TB1 and the selection frequency table TB2. FIG. 8 is a diagram showing an example of the frequency applied waveform 34a. FIG. 8 shows, in (a), a first example of basic waveform 301b shown in FIG. 2, and shows, in (b), the frequency applied waveform 34a generated based on the first example of basic waveform 301b.

The frequency applying unit 34 sequentially reads out the playback frequency fb from the selection frequency table TB2 while associating the elapsed time in the selection basic waveform table TB1 with the elapsed time in the selection frequency table TB2.

As shown in FIG. 8, the frequency applying unit 34 transforms the basic waveform 301b in the time axis direction Dt so that the time width Tfa of the basic waveform 301b in the selection basic waveform table TB1 becomes one period Tfb of the playback frequency fb in the selection frequency table TB2. The waveform obtained by transforming the basic waveform 301b in the time axis direction Dt (that is, the basic waveform 301b after transformation) corresponds the frequency applied waveform 34a. The transformation of the basic waveform 301b in the time axis direction Dt is, in detail, a compression of the basic waveform 301b in the time axis direction Dt. For example, the amplitude of the level in the basic waveform 301b in the selection basic waveform table TB1 is the same as the amplitude of the level in the frequency applied waveform 34a obtained by transforming the basic waveform 301b.

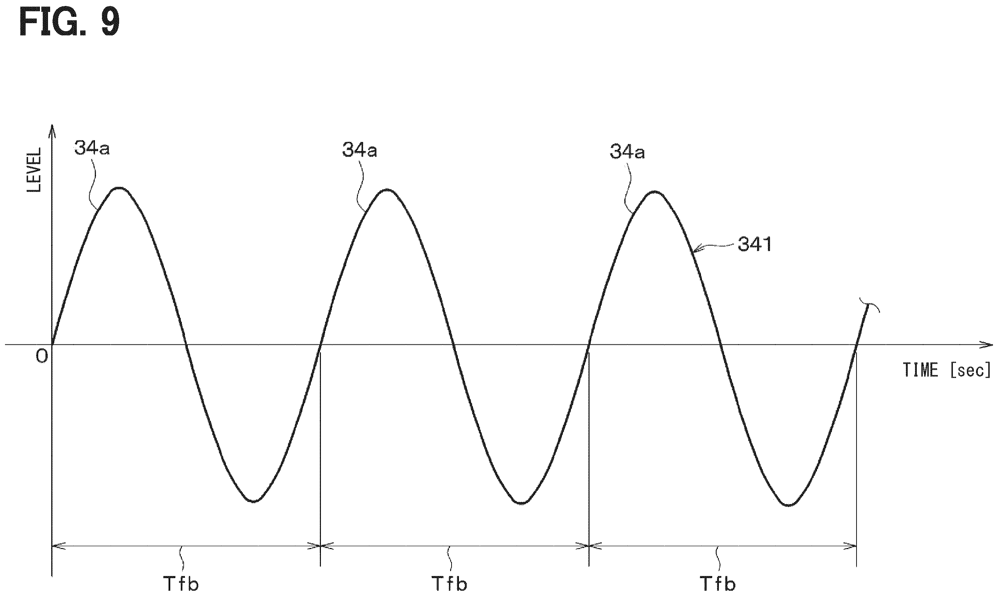

Then, as shown in FIG. 8 and FIG. 9, the frequency applying unit 34 obtains the frequency applied waveform 34a as described above, and generates a frequency applied continuous waveform 341, which is a waveform 341 in which the frequency applied waveform 34a is repeated successively, as the generation waveform data Da.

Note that one period Tfb of the above-described playback frequency fb is the reciprocal of the playback frequency fb, that is, Tfb = 1/fb. The one period Tfb of the above-described playback frequency fb corresponds to a time width that the frequency applied waveform 34a occupies in the time axis direction Dt as one period of the frequency applied waveform 34a. For example, when the playback frequency fb read from the selection frequency table TB2 is 100 Hz, one period Tfb of the playback frequency fb is Tfb = 1/fb = 0.01 sec.

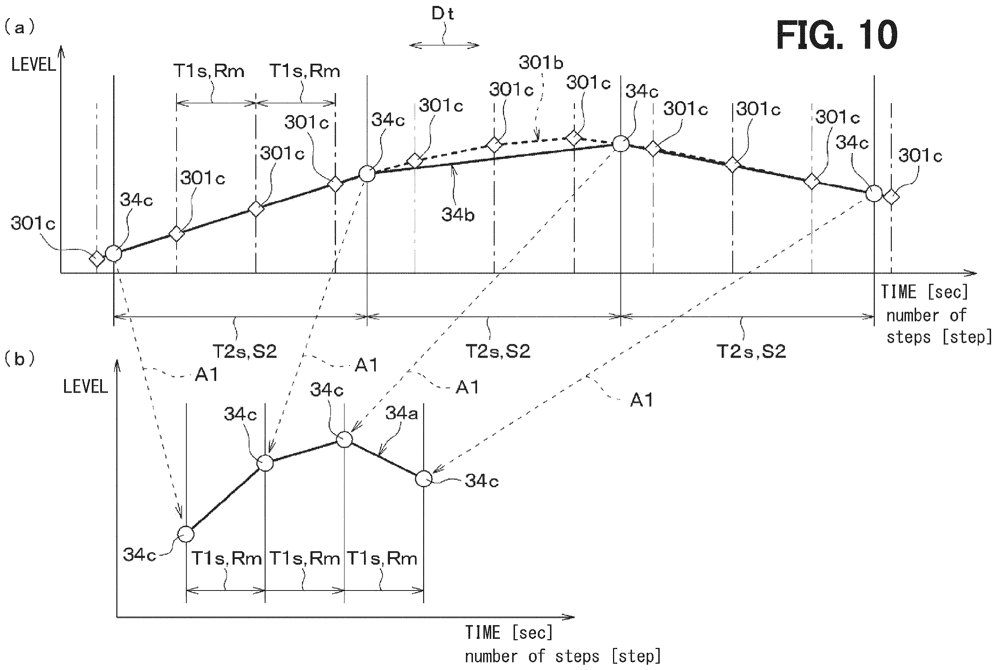

The following will describe a resampling process executed by the frequency applying unit 34 when obtaining the frequency applied waveform 34a. As shown in FIG. 10, the basic waveform 301b shown in (a) is digital data in which multiple first sample points 301c arranged at a first sampling period T1s are connected to form a waveform. The first sampling period T1s is the same as the sampling period of the sound generation system 8. Since the sampling period is the reciprocal of the sampling frequency, the first sampling period T1s is calculated based on the sampling frequency fss of the sound generation system 8 as T1s = 1/fss.

To obtain the frequency applied waveform 34a, the frequency applying unit 34 first provides multiple second sample points 34c at a second sampling period T2s along the basic waveform 301b of the selection basic waveform table TB1. As a result, the frequency applying unit 34 generates an intermediate waveform 34b formed by the multiple second sample points 34c.

At this time, the second sampling period T2s of the intermediate waveform 34b is calculated by the following formula F1.

$$T2s = Tfa \times fb \times T1s...(F1)$$

In the above formula F1, Tfa is the time width Tfa of the basic waveform 301b of the selection basic waveform table TB1, fb is the playback frequency fb of the selection frequency table TB2 used when transforming the basic waveform 301b in the time axis direction Dt, and T1s is the first sampling period T1s.

For example, when the basic waveform frequency fa of the basic waveform 301b of the selection basic waveform table TB1 is fa = 50 Hz, then Tfa in the above formula F1 becomes Tfa = 1/fa = 0.02 sec. When fb in the above formula F1 is fb = 160 Hz, then the second sampling period T2s shown in (b) of FIG. 10 becomes T2s = 3.2×T1s.

In order to reduce a calculating load of calculating the second sampling period T2s, for example, the sampling periods T1s and T2s are regarded as being composed of a large number of steps spaced at equal time intervals. Then, the resolution magnification Rm is set as the number of steps constituting the first sampling period T1s. A sample acquisition interval S2, which is the second sampling period T2s converted into the number of steps, is calculated by the following formula F2.

$$S2 = Rm \times fb/fa...(F2)$$

In the above formula F2, Rm is the resolution magnification Rm, fb is the same as that in the above formula F1, and fa is the basic waveform frequency fa of the basic waveform 301b of the selection basic waveform table TB1.

For example, when Rm in the above formula F2 is Rm = 1000 times = 1000 steps, fa is fa = 50 Hz, and fb is fb = 160 Hz, then the sample acquisition interval S2 is S2 = 1000 x 160/50 = 3200 steps. In this case, the first sampling period T1s shown in (a) of FIG. 10 is composed of 1000 steps, which is the same value as the resolution magnification Rm. The second sampling period T2s shown in (a) of FIG. 10 is composed of 3200 steps, which is the same value as the sample acquisition interval S2. The time interval Tstp per step is Tstp = T1s/Rm.

As described above, the frequency applying unit 34 calculates the sample acquisition interval S2, and generates the intermediate waveform 34b by arranging multiple second sample points 34c along the basic waveform 301b of the selection basic waveform table TB1 while leaving the sample acquisition interval S2 between two adjacent second sample points 34c in the time axis direction Dt.

After generating the intermediate waveform 34b as described above, the frequency applying unit 34 transforms the intermediate waveform 34b in the time axis direction Dt, as indicated by the arrow A1, to obtain the frequency applied waveform 34a. That is, the frequency applying unit 34 obtains, as the frequency applied waveform 34a, a waveform obtained by transforming the intermediate waveform 34b in the time axis direction Dt so that the second sampling period T2s of the intermediate waveform 34b is same as the first sampling period T1s.

The frequency applying unit 34 transforms the intermediate waveform 34b in the time axis direction Dt by changing the time interval between multiple second sample points 34c in the time axis direction Dt from the initial second sampling period T2s to the first sampling period T1s. The frequency applying unit 34 then obtains the transformed intermediate waveform 34b as the frequency applied waveform 34a. FIG. 10 shows, in (b), a portion of the frequency applied waveform 34a obtained by transforming the intermediate waveform 34b in the time axis direction Dt as described above.

As shown in (a) of FIG. 10, the frequency applying unit 34 may set the second sample point 34c between two adjacent first sample points 301c in the basic waveform 301b of the selection basic waveform table TB1. In this case, the frequency applying unit 34 determines the second sample point 34c between two adjacent first sample points 301c by interpolating two adjacent first sample points 301c. At this time, the interpolation between two adjacent first sample points 301c may be, for example, parabolic interpolation. In the present embodiment, linear interpolation is used.

As shown in FIG. 1, FIG. 6 and FIG. 7, the volume control unit 36 selects one volume table 361a from the multiple volume tables 361a stored in the third storage 361 as a selection volume table TB3. For example, the volume control unit 36 selects the selection volume table TB3 according to a predetermined rule in response to the vehicle state signal.

The volume control unit 36 acquires the generation waveform data Da generated by the frequency applying unit 34. The volume control unit 36 then sequentially reads out the target volume VT from the selection volume table TB3 while associating the elapsed time in the time axis of the generation waveform data Da with the elapsed time in the selection volume table TB3.

When the target volume VT is read out from the selection volume table TB3, the volume control unit 36 adjusts the generation waveform data Da so that the volume of the generation waveform data Da becomes the target volume VT of the selection volume table TB3, and generates the adjusted data as the output waveform data DW. Specifically, the volume control unit 36 generates the output waveform data DW by multiplying the generation waveform data Da by the target volume VT in the selection volume table TB3. The volume control unit 36 may reflect a volume balance of mixing to be executed in the mixer 42 in the volume control that determines the volume of the output waveform data DW.

The volume control unit 36 outputs the generation output waveform data DW to the mixer 42.

As described above, according to the present embodiment, one basic waveform table 301a is selected as the selection basic waveform table TB1 from multiple basic waveform tables 301a including respective multiple basic waveforms 301b. Further, one frequency table 321a is selected as the selection frequency table TB2 from multiple frequency tables 321a each of which indicates the relationship between the playback frequency fb and the elapsed time. The frequency applying unit 34 obtains the frequency applied waveform 34a by transforming the basic waveform 301b in the time axis direction Dt so that the time width Tfa of the basic waveform 301b in the selection basic waveform table TB1 becomes one period Tfb of the playback frequency fb in the selection frequency table TB2. Then, the frequency applying unit 34 generates a waveform 341 in which the frequency applied waveform 34a is repeated successively as the generation waveform data Da.

According to the above configuration, the total amount of data for the multiple basic waveform tables 301a and multiple frequency tables 321a is reduced compared with a case where sound source data are prepared, in advance, and stored independently for all combinations of the multiple basic waveform tables 301a and the multiple frequency tables 321a. Therefore, it is possible to reduce the size of data (that is, the amount of data) that serves as the sound source for outputting the sound by the sound output unit 80.

According to the above embodiment, a variety of sounds can be produced by combining multiple basic waveform tables 301a with the multiple frequency tables 321a. The sound generation system 8 of the present embodiment has a low cost and high mountability, and is capable of producing a variety of sounds. Further, an increase in the size of a product that includes the sound generation system 8 can be suppressed.

According to the present embodiment, one volume table 361a is selected as the selection volume table TB3 from multiple volume tables 361a each of which represents the relationship between the target volume VT and the elapsed time. The volume control unit 36 adjusts the generation waveform data Da so that the volume of generation waveform data Da becomes the target volume VT of the selection volume table TB3, and generates the adjusted data as the output waveform data DW. The sound output unit 80 then generates and outputs the sound based on the output waveform data DW.

According to the above configuration, it is possible to adjust the volume of output waveform data DW in a variety of ways while suppressing the amount of data that is provided as the source of sound output by the sound output unit 80.

According to the present embodiment, as shown in FIG. 10, the frequency applying unit 34 provides multiple second sample points 34c at the second sampling period T2s along the basic waveform 301b of the selection basic waveform table TB1. As a result, the frequency applying unit 34 generates the intermediate waveform 34b formed by the multiple second sample points 34c. Then, the frequency applying unit 34 transforms the intermediate waveform 34b in the time axis direction Dt so that the second sampling period T2s of the intermediate waveform 34b is same as the first sampling period T1s, and the waveform obtained by transforming the intermediate waveform 34b is set as the frequency applied waveform 34a.

With this configuration, it is possible to obtain the frequency applied waveform 34a while maintaining the sampling frequency for the basic waveform 301b before transformation.

(Other Embodiments)

(1) In the above embodiment, the sound generation system 8 is described as a warning device mounted on an automobile. However, this is merely an example. The sound generation system 8 does not have to be a warning device, and various uses of the sound generation system 8 are envisioned. The sound generation system 8 does not have to be equipped to a vehicle.

(2) In the above embodiment, as shown in FIG. 8, the transformation of the basic waveform 301b in the time axis direction Dt performed by the frequency applying unit 34 is, more specifically, a compression of the basic waveform 301b in the time axis direction Dt. The present disclosure is not limited to this example. For example, the transformation of the basic waveform 301b in the time axis direction Dt may be an extension of the basic waveform 301b in the time axis direction Dt.

(3) In the above embodiment, as shown in FIG. 1, each of the layers 16 of the microcomputer 10 has the volume control unit 36. The present disclosure is not limited to this example. For example, the volume control unit 36 may not be provided in each layer 16, and each layer 16 may output the generation waveform data Da as the output waveform data DW. In this case, the third storage 361 is not provided either.

(4) In the above embodiment, as shown in FIG. 1, the microcomputer 10 includes multiple layers 16. Alternatively, the microcomputer 10 may include only one layer 16. In this case, the mixer 42 is not provided, and the output waveform data DW is output from the microcomputer 10 to the DAC 12 as the sound data Dsd without being mixed with other output waveforms.

(5) In the above embodiment, each process executed by the microcomputer 10 is implemented by a computer program, but it may also be implemented by hardware circuits.

(6) The present disclosure is not limited to the above-described embodiment, and can be implemented in various modifications. Individual components or features of the above-described embodiment are not necessarily essential unless it is specifically stated that the components or the features are essential in the foregoing description, or unless the components or the features are obviously essential in principle.

The numerical value such as the number, value, quantity, range, or the like of components mentioned in the above-described embodiment is not limited to a specific number unless specified as being required, clearly limited to such a specific number in principle, or the like. The material, the shape, the positional relationship, and the like of a component or the like mentioned in the above embodiment are not limited to those being mentioned unless otherwise specified, or limited to specific material, shape, positional relationship, and the like in principle.

**Claims**

1. A sound generation control device (16) included in a sound generation system (8) and generating generation waveform data (Da) indicating a waveform of sound, the sound generation system causing a sound output unit (80) to output a sound generated based on the generation waveform data (Da), the sound generation control device comprising:

   a basic waveform selection unit (30) configured to select, as a selection basic waveform table (TB1), a basic waveform table from multiple basic waveform tables (301a) stored in advance, each of the multiple basic waveform tables having a basic waveform (301b) providing a basis of the generation waveform data;
   a frequency selection unit (32) configured to select, as a selection frequency table (TB2), a frequency table from multiple frequency tables (321a) stored in advance, each of the multiple frequency tables representing a relationship between a playback frequency (fb) and elapsed time, and the playback frequency indicating the number of times by which the basic waveform is transformed and repeated per unit time; and
   a frequency applying unit (34) configured to generate, as the generation waveform data, a waveform (341) in which a frequency applied waveform (34a) is repeated successively, the frequency applied waveform being obtained by transforming the basic waveform in a time axis direction (Dt) so that a time width (Tfa) of the basic waveform of the selection basic waveform table becomes one period (Tfb) of the playback frequency of the selection frequency table.

2. The sound generation control device according to claim 1, further comprising

   a volume control unit (36) configured to select, as a selection volume table (TB3), a volume table from multiple volume tables (361a) stored in advance, each of the volume tables representing a relationship between a target volume (VT) and elapsed time, the volume control unit further configured to adjust the generation waveform data so that a volume of the generation waveform data becomes the target volume of the selection volume table, and set the adjusted generation waveform data as output waveform data (DW),
wherein the sound output unit outputs the sound in accordance with the output waveform data.

3. The sound generation control device according to claim 1 or 2, wherein

the basic waveform is digital data in which multiple first sample points (301c) arranged at a first sampling period (T1s) are connected with one another to form a waveform,
the frequency applying unit generates an intermediate waveform (34b) by setting and arranging multiple second sample points (34c) along the basic waveform of the selection basic waveform table at a second sampling period (T2s),
when a time width of the basic waveform of the selection basic waveform table is indicated as Tfa, the playback frequency of the selection frequency table is indicated as fb, the first sampling period is indicated as T1s, and the second sampling period is indicated as T2s, the second sampling period is calculated by a formula $T2s = Tfa \times fb \times T1s$,
when arranging each of the multiple second sample points between two of the multiple first sample points adjacent to one another in the basic waveform of the selection basic waveform table, the frequency applying unit determines each of the multiple second sample points between two adjacent first sample points by interpolating the two adjacent first sample points, and
the frequency applying unit determines, as the frequency applied waveform, a waveform obtained by transforming the intermediate waveform in the time axis direction such that the second sampling period of the intermediate waveform is set to be same as the first sampling period.

# FIG. 1

EP 4 685 789 A1

# FIG. 2

# FIG. 3

# FIG. 4

PLAYBACK
FREQUENCY
fb

Dt

321a

10kHz

100Hz

0

TIME
[sec]

Twf

# FIG. 5

# FIG. 6

# FIG. 7

# FIG. 8

(a)

Dt

301b

301a,TB1

LEVEL

0

TIME [sec]

Tfa

(b)

34a

LEVEL

0

TIME [sec]

Tfb＝1／fb

FIG. 9

FIG. 10

## INTERNATIONAL SEARCH REPORT

| International application No. |
|---|
| **PCT/JP2024/005368** |

| | |
|---|---|
| **A.** | **CLASSIFICATION OF SUBJECT MATTER** |

*G10K 15/04*(2006.01)i; *B60Q 5/00*(2006.01)i; *H04R 3/00*(2006.01)i
FI:  G10K15/04 302F; H04R3/00 310; B60Q5/00 620A; B60Q5/00 660Z; B60Q5/00 630B; B60Q5/00 650B; B60Q5/00 650A

According to International Patent Classification (IPC) or to both national classification and IPC

| | |
|---|---|
| **B.** | **FIELDS SEARCHED** |

Minimum documentation searched (classification system followed by classification symbols)

G10K15/04; B60Q5/00; H04R3/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | WO 2014/184827 A1 (ANDEN CO., LTD.) 20 November 2014 (2014-11-20)<br>entire text, all drawings | 1-3 |
| A | JP 2005-115135 A (YAMAHA CORPORATION) 28 April 2005 (2005-04-28)<br>entire text, all drawings | 1-3 |

☐ Further documents are listed in the continuation of Box C.  ☑ See patent family annex.

| | | | |
|---|---|---|---|
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2024/005368**

| Patent document cited in search report | | | Publication date (day/month/year) | Patent family member(s) | | | Publication date (day/month/year) |
|---|---|---|---|---|---|---|---|
| WO | 2014/184827 | A1 | 20 November 2014 | US entire text, all drawings CN | 2016/0082882 105209296 | A1 A | |
| JP | 2005-115135 | A | 28 April 2005 | (Family: none) | | | |

Form PCT/ISA/210 (patent family annex) (July 2022)

**REFERENCES CITED IN THE DESCRIPTION**

**Patent documents cited in the description**

- JP 2023044828 A
- JP 2013018352 A